# EUROPEAN PATENT SPECIFICATION

(11) **EP 3 318 607 B1**
(45) Date of publication and mention of the grant of the patent: **04.09.2019**
(21) Application number: 16816968.8
(22) Date of filing: 29.03.2016
(51) Int. Cl.: C08L 83/07, C08L 63/00, C08L 83/05, C08K 7/20, C09D 183/07, C09D 163/00, H01L 31/0216, H01L 31/056

(54) **ORGANOSILICONE COMPOSITION, REFLECTIVE COATING, PREPARATION METHOD THEREFOR AND PHOTOVOLTAIC MODULE COMPRISING SAME**
ORGANOSILIKONZUSAMMENSETZUNG, REFLEKTIERENDE BESCHICHTUNG, HERSTELLUNGSVERFAHREN DAFÜR UND FOTOVOLTAIKMODUL DAMIT
COMPOSITION ORGANOSILICONÉE, REVÊTEMENT RÉFLÉCHISSANT, PROCÉDÉ DE PRÉPARATION CORRESPONDANT ET MODULE PHOTOVOLTAÏQUE LE COMPRENANT

(30) Priority: 30.06.2015 CN 201510373311
(43) Date of publication of application: 09.05.2018
(73) Proprietor: BYD Company Limited, Shenzhen, Guangdong 518118 (CN)
(72) Inventor: TANG, Fulan, Shenzhen Guangdong 518118 (CN); ZHOU, Wei, Shenzhen Guangdong 518118 (CN); LI, Xiankuan, Shenzhen Guangdong 518118 (CN)
(74) Representative: Gulde & Partner
(86) International application number: PCT/CN2016/077690
(87) International publication number: WO 2017/000603

(56) References cited:
- EP-A1- 2 551 929
- WO-A1-01/12895
- WO-A1-2012/094885
- WO-A1-2014/119930
- CN-A- 101 517 002
- CN-A- 101 643 582
- CN-A- 101 712 800
- CN-A- 103 122 149

## Description

### Technical Field

The present disclosure relates to the technical field of photovoltaic batteries, and particularly to a silicone composition, a reflective coating and a preparation method therefor, and a photovoltaic assembly comprising the reflective coating.

### Related Art

Photovoltaic battery assembly (solar battery assembly) is a product that directly converts the solar energy into electrical energy through a P-N junction by means of the photovoltaic effect of silicon and other semiconductors. In the photovoltaic battery assembly, when a back panel is made with a transparent material, a reflective coating is usually provided on the back panel to reflect the light transmitted onto the back panel back to the cell, so as to increase the solar energy utilization, thereby improving the overall performance of the assembly and ensuring the safe and stable operation of a photovoltaic power generation system.

At present, the reflective coating used in a photovoltaic battery assembly is generally formed by manually coating a one-component condensation-type silicone adhesive on a back plate and then subjecting to moisture curing. During use, the one-component condensation-type silicone adhesive can be cured at room temperature under the action of moisture without heating, and thus the process is simple. However, due to the limitations from the properties of the one-component condensation-type silicone adhesive per se, the following problems exist during use: (1) slow deep-section curing, where 24 hrs or more is needed for 5 mm curing; (2) high viscosity of the adhesive as a paste, where during use, the thickness is difficult to control, and the problems of difficult application, poor uniformity, and low efficiency exist when the position to be coated is irregular; and (3) release of small molecules upon curing, where if remaining in the coating, the small molecules will affect the coating performance.

To overcome the above problems, attempts are made by the researchers to use a two-component silicone adhesive with a fast curing rate. However, the bonding strength of the two-component silicone adhesive is often far below that of the one-component condensation-type silicone adhesive. This causes the delamination of the reflective coating, thus being not conducive to the production and application. WO01/12895 discloses a similar silicone composition.

### SUMMARY

An object of the present disclosure is to provide a silicone composition, a reflective coating and a preparation method therefor, and a photovoltaic assembly comprising the reflective coating, so as to reduce the curing time of the reflective coating prepared with the silicone composition and increase the adhesion force of the reflective coating.

To achieve the above object, in a first aspect of the present disclosure, a silicone composition is provided as defined in claim 1.

In a second aspect of the present disclosure, a reflective coating is provided, which is formed by curing the silicone composition after mixing.

In a third aspect of the present disclosure, a method for preparing the reflective coating is provided as defined in claim 11.

The silicone adhesive composition has a much more moderate bonding strength. By means of the silicone adhesive composition, the curing time is reduced and the adhesion force of a reflective coating prepared therewith is increased. Meanwhile, in the silicone adhesive composition, a high proportion of a reflective material can be mixed to obtain a high reflectivity, thereby improving the solar energy utilization of a photovoltaic assembly containing the reflective coating prepared therefrom.

Other features and advantages of the present disclosure will be described in detail in the following detailed description.

### DETAILED DESCRIPTION

Hereinafter, specific embodiments of the present disclosure will be described in detail. It is to be understood that the specific embodiments described herein are provided merely for the purpose of illustration and explanation and not intended to limit the scope of the present disclosure.

The term "Vi" as used herein refers to vinyl, the "Si-Vi bond" refers to a linkage formed by a silicon atom with a vinyl group, and the "Si-H" refers to a linkage formed by a silicon atom with a hydrogen atom.

As is pointed out in the prior art, during the preparation of a reflective coating, problems exist that the one-component condensation-type silicone adhesive has a large viscosity, and is slow in deep-section curing and difficult in application, and the two-component silicone adhesive generally has a low viscosity and tends to delaminate. To overcome these problems, the present invention provides a silicone composition. The silicone composition comprises a base polymer component, a catalyst, a cross-linking agent and reflective particles. The base polymer component, the catalyst and the cross-linking agent are not mixed simultaneously before use. The base polymer component comprises 100 parts by weight of a polymethylsiloxane, which is at least one of α,ω-divinyl polydimethyl siloxane and vinyldimethylsiloxy capped polydimethylmethylvinylsiloxane, 5-15 parts by weight of a hydrogenated epoxy resin- or cycloaliphatic epoxy resin-modified polymethylvinylsiloxane terminated with a hydroxyl group, and 10-20 parts by weight of a siloxane resin having at least two Si-Vi bonds. The cross-linking agent is a polyorganosiloxane having at least two Si-H bonds.

The present disclosure relates to the above-mentioned silicone composition, and a reflective coating and a preparation method therefor. By using a liquid polysiloxane having at least two Si-Vi bonds per molecule, a hydrogenated epoxy resin- or cycloaliphatic epoxy resin-modified polymethylvinylsiloxane terminated with a hydroxyl group, and a siloxane resin having at least two Si-Vi bonds as a base polymer component, and a polyorganosiloxane having at least two Si-H bonds as a cross-linking agent, a silicone adhesive composition with a much more moderate bonding strength can be obtained. By means of the silicone adhesive composition, the curing time is reduced and the adhesion force of a reflective coating prepared therewith is increased. Meanwhile, in the silicone adhesive composition, a high proportion of a reflective material can be mixed to obtain a high reflectivity, thereby improving the solar energy utilization of a photovoltaic assembly containing a reflective coating prepared therefrom.

For the purpose of facilitating the adjustment of the viscosity of a silicone adhesive formed after mixing the silicone composition and increasing the reaction rate of the silicone adhesive, the silicone composition comprises a component A and a component B, where the component A at least comprises a portion of the base polymer component, and the catalyst, and the component B at least comprises the remaining portion of the base polymer component, and the cross-linking agent. By dividing the silicone composition into the component A and the component B and then mixing the component A and the component B to form a silicone adhesive, the viscosity of the silicone adhesive is facilitated to be adjusted, whereby the prepared silicone adhesive has a processability that allows it to be applied onto a back panel by screen printing.

In the silicone composition, the component A comprises 45-55 parts by weight of at least one of α,ω-divinyl polydimethyl siloxane and vinyldimethylsiloxy capped polydimethylmethylvinylsiloxane; 2.5-7.5 parts by weight of the hydrogenated epoxy resin-or cycloaliphatic epoxy resin-modified polymethylvinylsiloxane terminated with a hydroxyl group; 5-10 parts by weight of the siloxane resin having at least two Si-Vi bonds, wherein the siloxane resin has a vinyl content of 0.5-1.5 wt.%; 0.015-0.075 parts by weight of the catalyst; and 1.5-5 parts by weight of the reflective particles; and the component B comprises 45-55 parts by weight of at least one of α,ω-divinyl polydimethyl siloxane and vinyldimethylsiloxy capped polydimethylmethylvinylsiloxane; 2.5-7.5 parts by weight of the hydrogenated epoxy resin- or cycloaliphatic epoxy resin-modified polymethylvinylsiloxane terminated with a hydroxyl group; 5-10 parts by weight of the siloxane resin having at least two Si-Vi bonds, wherein the siloxane resin has a vinyl content of 0.5-1.5 wt.%; 0.75-10 parts by weight of the polyorganosiloxane cross-linking agent having at least two Si-H bonds; and 1.5-5 parts by weight of the reflective particles.

In the silicone composition provided in the present disclosure, the raw materials used are not particularly limited, and the effects mentioned in the present disclosure can be achieved as long as the polymethylsiloxane and the siloxane resin have the required Si-Vi bonds, the polyorganosiloxane cross-linking agent has the required Si-H bonds, and the polymethylvinylsiloxane terminated with a hydroxyl group is modified with a hydrogenated epoxy resin or a cycloaliphatic epoxy resin. However, to further optimize the processability and usability of the silicone adhesive formed after mixing the silicone composition, the raw materials in the silicone composition may be suitably selected, specifically as described below.

Optionally, the polymethylsiloxane having at least two Si-Vi bonds per molecule used in the silicone composition has a vinyl content of 0.02-0.8 wt.%, and a viscosity of 200-500,000 cP. The viscosity of the silicone composition is facilitated to be adjusted by controlling the vinyl (Vi) content in the polymethylsiloxane having at least two Si-Vi bonds, thereby controlling the coatability and the coating thickness of the silicone adhesive.

The polymethylsiloxane having at least two Si-Vi bonds per molecule used in the present disclosure is at least one of α,ω-divinyl polydimethyl siloxane and vinyldimethylsiloxy capped polydimethylmethylvinylsiloxane.

The polymethylsiloxane may be a commercially available product, or be synthesized according to a conventional synthesis process. Commercially available products include, but are not limited to, α,ω-divinyl polydimethyl siloxane (vinyl content: 0.1-0.4wt.%, and viscosity at 25°C: 500-10000 cP) and vinyldimethylsiloxy capped polydimethylmethylvinylsiloxane (vinyl content: 0.5-2.0wt.%, and viscosity at 25°C: 200-15000 cP) commercially available from AB Specialty Silicones Co., Ltd; α,ω-divinyl polydimethyl siloxane (vinyl content: 0.12-0.42wt.%, and viscosity at 25°C: 500-10000 cP) commercially available from Zhejiang Runhe Co., Ltd; or α,ω-divinyl polydimethyl siloxane (vinyl content: 0.15-0.45wt.%, and viscosity at 25°C: 500-10000 cP) commercially available from Arit Co., Ltd.

Optionally, in the silicone composition, the hydrogenated epoxy resin- or cycloaliphatic epoxy resin-modified polymethylvinylsiloxane terminated with a hydroxyl group is a modified product formed through the polymerization reaction of a hydrogenated epoxy resin or a cycloaliphatic epoxy resin with a methylvinyl polysiloxane terminated with a hydroxyl group, at a weight ratio of 1:0.5-2.5. The proportion of the epoxy resin in the whole coating is facilitated to be controlled, by controlling the weight ratio of the epoxy resin to the methylvinyl polysiloxane terminated with a hydroxyl group in the hydrogenated epoxy resin- or cycloaliphatic epoxy resin-modified polymethylvinylsiloxane terminated with a hydroxyl group, thereby facilitating the improvement of the bonding strength of the coating.

The hydrogenated epoxy resin- or cycloaliphatic epoxy resin-modified polymethylvinylsiloxane terminated with a hydroxyl group useful in the present disclosure may be a commercially available product, or be synthesized according to a conventional synthesis process. In an optional embodiment of the present disclosure, a method for synthesizing the hydrogenated epoxy resin- or cycloaliphatic epoxy resin-modified polymethylvinylsiloxane terminated with a hydroxyl group comprises: reacting a hydrogenated epoxy resin or a cycloaliphatic epoxy resin with a methylvinyl polysiloxane terminated with a hydroxyl group for 6-12 hrs at 100-150°C in the presence of a catalyst (e.g. triphenylphosphine), to obtain a reaction product.

During the synthesis of the hydrogenated epoxy resin- or cycloaliphatic epoxy resin-modified polymethylvinylsiloxane terminated with a hydroxyl group, useful hydrogenated epoxy resins include, but are not limited to, hydrogenated bisphenol A epoxy resin and/or hydrogenated bisphenol F epoxy resin. Optionally, the hydrogenated epoxy resin or cycloaliphatic epoxy resin has an epoxy equivalent of 130-250. When the epoxy equivalent is controlled to fall within the above-mentioned range, the functional group content in the hydrogenated epoxy resin or cycloaliphatic epoxy resin can be ensured, and the product is ensured to be in a flowing state at normal temperature.

The vinyl (Vi) content of the siloxane resin having at least two Si-Vi bonds in the silicone composition is 0.5-1.5 wt.%. By defining the Vi content of the siloxane resin having at least two Si-Vi bonds in such a range, the compatibility between the resin and the silicone can be ensured on one hand, and the strength and toughness of the coating can be optimized to allow them to reach a balance on the other hand. Optionally, the siloxane resin having at least two Si-Vi bonds comprises SiO_{4/2} and one or more of R₁SiO_{3/2}, R₂SiO_{2/2} and R₃SiO_{1/2}, where R₁, R₂, and R₃ may be the same or different and is Me (CH₃-, methyl) or Vi (vinyl). The silicone resin having at least two Si-Vi bonds and comprising the above-mentioned structure can promote the polymerization reaction of the siloxane resin, thereby achieving the effect of improving the coating strength.

The siloxane resin having at least two Si-Vi bonds useful in the present invention includes, but is not limited to, MQ silicone resin, MDQ silicone resin, and MTQ silicone resin.

The MQ silicone resin comprises a monofunctional silicon-oxygen unit (M, R₃SiO_{1/2}, where R₃ is methyl or vinyl) and a tetrafunctional silicon-oxygen unit (Q, SiO_{4/2}), for example, an MQ silicone resin with an M/Q ratio of 0.6-0.9, for example, VQM60 MQ silicone resin (vinyl content: 0.54%, and M/Q=0.6) commercially available from AB Specialty Silicones Co., Ltd, and XB-82063 MQ silicone resin (vinyl content: 1-4%, and M/Q=0.6-0.9) commercially available from Xibo Chemical Technology Co., Ltd.

The MDQ silicone resin comprises a monofunctional silicon-oxygen unit (M, R₃SiO_{1/2}, where R is methyl or vinyl), a difunctional silicon-oxygen unit (D, R₂SiO_{2/2}, where R is methyl or vinyl), and a tetrafunctional silicon-oxygen unit (Q, SiO_{4/2}).

The MTQ silicone resin comprises a monofunctional silicon-oxygen unit (M, R₃SiO_{1/2}, where R is methyl or vinyl), a trifunctional silicon-oxygen unit (T, R₁SiO_{3/2}, where R is methyl or vinyl), and a tetrafunctional silicon-oxygen unit (Q, SiO_{4/2}).

Optionally, the hydrogen content of the polyorganosiloxane cross-linking agent having at least two Si-H bonds in the silicone composition is 0.1-1 wt.%. In the present disclosure, the mechanical performance and the reaction rate of the adhesive layer are facilitated to be controlled by controlling the hydrogen content of the cross-linking agent.

The polyorganosiloxane having at least two Si-H bonds useful in the present disclosure includes, but is not limited to, at least one of trimethylsiloxy capped dimethylmethylhydrogen polysiloxane and Si-H dimethyl capped dimethylmethylhydrogen polysiloxane.

Optionally, the catalyst useful in the silicone composition can be selected according to the reaction principle, and includes, but is not limited to, nickel, palladium, osmium, iridium, platinum and other transition metal compounds. Optionally, the catalyst is a platinum catalyst, and the use of a platinum catalyst can facilitate the acquisition of a suitable curing rate. For example, the platinum catalyst is a platinum-vinyl siloxane complex, in which the platinum content is 500-5000 ppm. The curing rate is facilitated to be controlled by using a platinum-vinyl siloxane complex and controlling the platinum content.

Optionally, the reflective particles useful in the silicone composition include, but are not limited to, reflective glass microspheres. Reflective glass microspheres having a particle size of 0.5 to 3 µm can be used. The use of reflective glass microspheres having a particle size of 0.5 to 3 µm is advantageous in that the reflective glass microspheres are more uniformly dispersed, thus achieving a better reflection effect, thereby improving the reflectivity, and further improving the solar energy utilization.

In the silicone composition, to adjust the service life of the coating prepared, an inhibitor may be further comprised. In an optional embodiment of the present disclosure, the silicone composition further comprises, based on 100 parts by weight of the polymethylsiloxane having at least two Si-Vi bonds per molecule, 0.002-0.005 parts by weight of an inhibitor. Optionally, when the silicone composition comprises a component A and a component B, the inhibitor is mixed in the component B.

The inhibitor useful in the present disclosure includes, but is not limited to, one or more of 2-methyl-3-butyn-2-ol, 2-phenyl-3-butyn-2-ol, 3,5-dimethyl-1-hexyn-3-ol, 1-hexyn-1-cyclohexanol, 3-ethyl-3-buten-1-yne, 1,3-divinyl tetramethyldisiloxane, 1,3,5,7-tetravinyltetramethylcyclotetarsiloxane, 1,3-divinyl tetramethyldisiloxane, methyl tris(3-methyl-1-butyn-3-oxy)silane, tetramethylethylenediamine, benzotriazole, triphenylphosphine, and malaic acid derivatives. For example, an alkyne inhibitor is used.

In the silicone composition, to ensure the retention of the bonding strength of the silicone adhesive after aging, a tackifier may be further comprised. In an optional embodiment of the present disclosure, the silicone composition further comprises, based on 100 parts by weight of the polymethylsiloxane having at least two Si-Vi bonds per molecule, 0.05-0.3 parts by weight of a tackifier. Optionally, when the silicone composition comprises a component A and a component B, the tackifier is mixed in the component B. In the present disclosure, the tackifier can be prevented from reacting with the raw materials in the component A in advance by mixing the tackifier and the cross-linking agent together in the component B.

Optionally, the tackifier is one or more selected from vinyltriethoxysilane, acryloylpropyltrimethoxysilane, alkylacryloylpropyltrimethoxysilane, allyltriethoxysilane, epoxypropoxypropyltrimethoxysilane, allylglycidyl ether, an adduct of siloxane having a Si-H bond with allylglycidyl ether or methylacryloyloxy propyltrimethoxysilane, and a polycondensate prepared by cohydrolysis of trimethoxysilane with allyltrimethoxysilane.

In the silicone composition, to further increase the mechanical performance and the bonding property of the adhesive layer, a mechanical functional filler may be further comprised. In an optional embodiment of the present disclosure, the silicone composition further comprises, based on 100 parts by weight of the polymethylsiloxane having at least two Si-Vi bonds per molecule, 5-20 parts by weight of a mechanical functional filler. Optionally, when the silicone composition comprises a component A and a component B, the component A comprises 6-10 parts by weight of the mechanical functional filler, and the component B comprises 6-10 parts by weight of the mechanical functional filler. By mixing the mechanical functional filler respectively in the component A and the component B, the mechanical functional filler can be more uniformly mixed with other raw materials, thereby enhancing the uniformity of the mechanical performance and the bonding property of the adhesive layer.

Optionally, the mechanical functional filler is a hydrophobically treated filler particle. Optionally, the filler particle is one or more of white carbon black (gas-phase method white carbon black), activated calcium carbonate, fine silica powder, diatomaceous earth and titanium dioxide (titanium dioxide powder, and gas-phase method titanium dioxide). In the present disclosure, the addition of the above filler can improve the mechanical performance and the bonding property of the adhesive layer. Optionally, the filler particle has a particle size of 0.5-3 µm.

In the present disclosure, a reflective coating is further provided, which is formed by mixing and then curing the silicone composition. The reflective coating provided in the present disclosure is prepared with the silicone composition, and has excellent adhesion performance and excellent reflectivity, thereby facilitating the improvement of the solar energy utilization.

In the present disclosure, a method for preparing the reflective coating is further provided. The preparation method comprises the steps of: mixing a portion of a base polymer component, a portion of reflective particles, an optional mechanical functional filler, and a catalyst under a first stirring condition, to obtain a mixed component A; mixing the remaining base polymer component, the remaining reflective particles, the optional mechanical functional filler, a cross-linking agent, an optional inhibitor, and an optional tackifier under a second stirring condition, to obtain a mixed component B; mixing the mixed component A and the mixed component B with stirring, to obtain a pre-material having a viscosity of 6000-10000 cP; and applying the pre-material onto a substrate, and curing under a curing condition, to form the reflective coating. The base polymer component comprises 100 parts by weight of a polymethylsiloxane having at least two Si-Vi bonds per molecule, 5-15 parts by weight of a hydrogenated epoxy resin- or cycloaliphatic epoxy resin-modified polymethylvinylsiloxane terminated with a hydroxyl group, and 10-20 parts by weight of a siloxane resin having at least two Si-Vi bonds. The cross-linking agent is a polyorganosiloxane having at least two Si-H bonds.

For saving energy, in an optional embodiment, the steps of preparing the mixed component A and the mixed component B in the method for preparing the reflective coating comprises bringing the base polymer component, the reflective particles and the optional mechanical functional filler into contact and mixing them in proportion with stirring (high-speed stirring at 2000-7000 rpm for 20-40 min), to obtain a mixture, and dividing the mixture into a mixture A and a mixture B; mixing the mixture A with the catalyst, to obtain the mixed component A; and mixing the mixture B with the cross-linking agent, the optional inhibitor, and the optional tackifier, to obtain the mixed component B.

Optionally, in the preparation method, the first stirring condition and the second stirring condition comprise respectively high-speed stirring at 2000-7000 rpm for 20-40 min; and the curing condition comprises baking at 120-150°C for 5-15 min.

Optionally, the preparation method further comprises steps of grinding the mixtures respectively before the step of mixing the mixed component A and the mixed component B with stirring. Optionally, the grinding condition comprises grinding 2-3 times in a three-roller grinding mill with an inter-roller gap of 20-35 µm, to obtain a mixed component having a fineness of 20-35 µm.

In the present disclosure, a photovoltaic assembly is further provided, which comprises a back panel and a reflective coating covering the back panel, where the reflective coating is a reflective coating as described above. By using the above-mentioned reflective coating having good adhesion force and reflectivity, the service life of the photovoltaic assembly is prolonged and the solar energy utilization is enhanced.

The beneficial effects of the present disclosure will be further described below in connection with specific examples and comparative examples (in the following examples, the raw materials are each added in parts by weight).

### Example 1

### (I) Preparation of the hydrogenated epoxy resin-modified polymethylvinylsiloxane terminated with a hydroxyl group

100 parts of hydrogenated bis-phenol A epoxy resin (EPALLOY 5000 commercially available from CVC Corp., epoxy equivalent: 230) was reacted with 70 parts of methylvinyl polysiloxane terminated with a hydroxyl group (DA30 commercially available from AB Specialty Silicones Co., Ltd, vinyl content: 0.6%) at 120°C for 9 hrs in the presence of triphenylphosphine as a catalyst, to obtain a reaction product.

### (II) Material mixing of the component A and the component B in the silicone composition

Mixing of the component A: 100 parts of α,ω-divinyl polydimethyl siloxane (VS5000 commercially available from AB Specialty Silicones Co., Ltd, vinyl content: 0.16%, and viscosity (at 25°C): 5000 cP), 10 parts of the hydrogenated epoxy resin-modified polymethylvinylsiloxane terminated with a hydroxyl group, 10 parts of MQ silicone resin (VQM60 commercially available from AB Specialty Silicones Co., Ltd, vinyl content: 0.5%, and M/Q=0.65), 10 parts of titanium dioxide powder (particle size: 1 µm), 2 parts of fumed silica (particle size: 0.5 µm), 10 parts of reflective glass microspheres (particle size: 2 µm), and 0.04 parts of Kaarst platinum catalyst (SYC-off 4000 catalyst commercially available from Dow Corning, in which the content of platinum is 0.5 wt%) were stirred for 30 min at a rotation speed of 500 rpm, and then ground two times in a three-roller grinding mill (grinding parameter: inter-roller gap 30 µm), to obtain the component A having a fineness of 22 µm.

Mixing of the component B: 97.09 parts of α,ω-divinyl polydimethyl siloxane (VS5000 commercially available from AB Specialty Silicones Co., Ltd, vinyl content: 0.16%, and viscosity (at 25°C): 5000 cP), 10 parts of the hydrogenated epoxy resin-modified polymethylvinylsiloxane terminated with a hydroxyl group, 10 parts of MDQ silicone resin (vinyl content: 0.5%, and M/D/Q=3/3/4), 10 parts of titanium dioxide powder (particle size: 1 µm), 2 parts of fumed silica (particle size: 0.5 µm), 10 parts of reflective glass microspheres (particle size: 2 µm), 2.8 parts of Si-H dimethyl capped dimethylmethylhydrogen polysiloxane (XL10 commercially available from AB Specialty Silicones Co., Ltd, hydrogen content: 0.75 wt.%), 0.005 parts of 1-hexyn-1-cyclohexanol, and 0.15 parts of epoxypropoxypropyltrimethoxysilane were stirred for 30 min at a rotation speed of 500 rpm, and then ground two times in a three-roller grinding mill (grinding parameter: inter-roller gap 30 µm), to obtain the component B having a fineness of 25 µm.

### (III) Preparation of the reflective coating

The component A and the component B were uniformly mixed at a weight ratio of 1: 1, to obtain a mixture having a viscosity of 7800 cP. The uniformly mixed silicone composition was printed onto a site of a back panel where reflection was needed by using a 100-mesh screen printing machine and then baked at 150°C for 10 min to form a reflective coating.

### Example 2

### (I) Preparation of the hydrogenated epoxy resin-modified polymethylvinylsiloxane terminated with a hydroxyl group

100 parts of hydrogenated bis-phenol A epoxy resin (EPALLOY 5000 commercially available from CVC Corp., epoxy equivalent: 230) was reacted with 200 parts of methylvinyl polysiloxane terminated with a hydroxyl group (DA30 commercially available from AB Specialty Silicones Co., Ltd, vinyl content: 0.6%) at 120°C for 9 hrs in the presence of triphenylphosphine as a catalyst, to obtain a reaction product.

### (II) Material mixing of the component A and the component B in the silicone composition

Mixing of the component A: 81 parts of vinyldimethylsiloxy capped polydimethyl siloxane (RH301 commercially available from Runhe Co., Ltd, vinyl content: 0.04%, and viscosity (at 25°C): 100000 cP), 19 parts of vinyldimethylsiloxy capped polydimethyl siloxane (VS200 commercially available from AB Specialty Silicones Co., Ltd, vinyl content: 0.675%, and viscosity (at 25°C): 200 cP), 10 parts of the hydrogenated epoxy resin-modified polymethylvinylsiloxane terminated with a hydroxyl group, 10 parts of MQ silicone resin (XB-82062 commercially available from Xibo Chemical Technology Co., Ltd, vinyl content: 4%, and M/Q=0.6), 10 parts of titanium dioxide powder (particle size: 1 µm), 2 parts of fumed silica (particle size: 0.5 µm), 10 parts of reflective glass microspheres (particle size: 2 µm), and 0.04 parts of Kaarst platinum catalyst (SYC-off 4000 commercially available from Dow Corning, in which the content of platinum is 0.5%) were stirred for 30 min at a rotation speed of 500 rpm, and then ground two times in a three-roller grinding mill (grinding parameter: inter-roller gap 30 µm), to obtain the component A having a fineness of 25 µm.

Mixing of the component B: 75 parts of vinyldimethylsiloxy capped polydimethyl siloxane (RH301 commercially available from Runhe Co., Ltd, vinyl content: 0.04%, and viscosity (at 25°C): 100000 cP), 17.62 parts of vinyldimethylsiloxy capped polydimethyl siloxane (VS200 commercially available from AB Specialty Silicones Co., Ltd, vinyl content: 0.675%, and viscosity (at 25°C): 200 cP), 10 parts of the hydrogenated epoxy resin-modified polymethylvinylsiloxane terminated with a hydroxyl group, 10 parts of MQ silicone resin (XB-82062 commercially available from Xibo Chemical Technology Co., Ltd, vinyl content: 4%, and M/Q=0.6), 10 parts of titanium dioxide powder (particle size: 1 µm), 2 parts of fumed silica (particle size: 0.5 µm), 10 parts of reflective glass microspheres (particle size: 2 µm), 7.16 parts of Si-H dimethyl capped dimethylmethylhydrogen polysiloxane (XL10 commercially available from AB Specialty Silicones Co., Ltd, hydrogen content: 0.75 wt.%)), 0.005 parts of 1-hexyn-1-cyclohexanol, and 0.15 parts of epoxypropoxypropyltrimethoxysilane were stirred for 30 min at a rotation speed of 500 rpm, and then ground two times in a three-roller grinding mill (grinding parameter: inter-roller gap 30 µm), to obtain the component B having a fineness of 24 µm.

### (III) Preparation of the reflective coating

The component A and the component B were uniformly mixed at a weight ratio of 1: 1, to obtain a mixture having a viscosity of 9600 cP. The uniformly mixed silicone composition was printed onto a site of a back panel where reflection was needed by using a 100-mesh screen printing machine and then baked at 150°C for 10 min to form a reflective coating.

### Example 3

(I) Preparation of the hydrogenated epoxy resin-modified polymethylvinylsiloxane terminated with a hydroxyl group: The preparation method was the same as the method for preparing the epoxy resin-modified polymethylvinylsiloxane terminated with a hydroxyl group as described in Example 2.
(II) Material mixing of the component A and the component B in the silicone composition

Mixing of the component A: 100 parts of α,ω-divinyl polydimethyl siloxane (VS5000 commercially available from AB Specialty Silicones Co., Ltd, vinyl content: 0.16%, and viscosity (at 25°C): 5000 cP), 10 parts of the hydrogenated epoxy resin-modified polymethylvinylsiloxane terminated with a hydroxyl group, 10 parts of MQ silicone resin (VQM60 commercially available from AB Specialty Silicones Co., Ltd, vinyl content: 0.5%, and M/Q=0.65), 10 parts of titanium dioxide powder (particle size: 0.2µm), 2 parts of fumed silica (particle size: 0.3µm), 10 parts of reflective glass microspheres (particle size: 1.5µm), 10 parts of reflective glass microspheres (particle size: 1.5 µm), and 0.04 parts of Kaarst platinum catalyst (SYC-off 4000 commercially available from Dow Corning, in which the content of platinum is 0.5%) were stirred for 30 min at a rotation speed of 500 rpm, and then ground two times in a three-roller grinding mill (grinding parameter: inter-roller gap 30 µm), to obtain the component A having a fineness of 25 µm.

Mixing of the component B: 94.4 parts of α,ω-divinyl polydimethyl siloxane (VS5000 commercially available from AB Specialty Silicones Co., Ltd, vinyl content: 0.16%, and viscosity (at 25°C): 5000 cP), 10 parts of the hydrogenated epoxy resin-modified polymethylvinylsiloxane terminated with a hydroxyl group, 10 parts of MQ silicone resin (VQM60 commercially available from AB Specialty Silicones Co., Ltd, vinyl content: 0.5%, and M/Q=0.65), 10 parts of titanium dioxide powder (particle size: 0.2 µm), 2 parts of fumed silica (particle size: 0.3 µm), 10 parts of reflective glass microspheres (particle size: 1.5 µm), 4.6 parts of Si-H dimethyl capped dimethylmethylhydrogen polysiloxane (XB-711 commercially available from Xibo Chemical Technology Co., Ltd, hydrogen content: 0.45 wt.%), 0.005 parts of 1-hexyn-1-cyclohexanol, and 0.15 parts of epoxypropoxypropyltrimethoxysilane were stirred for 30 min at a rotation speed of 500 rpm, and then ground two times in a three-roller grinding mill (grinding parameter: inter-roller gap 30 µm), to obtain the component B having a fineness of 25 µm.

### (III) Preparation of the reflective coating

The component A and the component B were uniformly mixed at a weight ratio of 1: 1, to obtain a mixture having a viscosity of 7800 cP. The uniformly mixed silicone composition was printed onto a site of a back panel where reflection was needed by using a 100-mesh screen printing machine and then baked at 150°C for 10 min to form a reflective coating.

### Example 4

### (I) Preparation of the hydrogenated epoxy resin-modified polymethylvinylsiloxane terminated with a hydroxyl group

100 parts of hydrogenated bis-phenol Aepoxy resin (YL6753 commercially available from Shanghai Zhongshi Co., Ltd., epoxy equivalent: 180) was reacted with 255 parts of methylvinyl polysiloxane terminated with a hydroxyl group (DA30 commercially available from AB Specialty Silicones Co., Ltd, vinyl content: 0.6%) at 120°C for 9 hrs in the presence of triphenylphosphine as a catalyst, to obtain a reaction product.

### (II) Material mixing of the component A and the component B in the silicone composition

Mixing of the component A: 80 parts of α,ω-divinyl polydimethyl siloxane (VS2000 commercially available from AB Specialty Silicones Co., Ltd, vinyl content: 0.2 %, and viscosity (at 25°C): 2000 cP), 20 parts of vinyldimethylsiloxy capped polydimethylmethylvinyl siloxane (VDM65000 commercially available from AB Specialty Silicones Co., Ltd, vinyl content: 3.5%), 10 parts of the hydrogenated epoxy resin-modified polymethylvinylsiloxane terminated with a hydroxyl group, 10 parts of MQ silicone resin (VQM60 commercially available from AB Specialty Silicones Co., Ltd, vinyl content: 0.5%, and M/Q=0.65), 10 parts of titanium dioxide powder (particle size: 0.5 µm), 2 parts of fumed silica (particle size: 0.2 µm), 10 parts of reflective glass microspheres (particle size: 1.5 µm), 0.04 parts of Kaarst platinum catalyst (SYC-off 4000 commercially available from Dow Corning, in which the content of platinum is 0.5%) were stirred for 30 min at a rotation speed of 500 rpm, and then ground two times in a three-roller grinding mill (grinding parameter: inter-roller gap 30 µm), to obtain the component A having a fineness of 24 µm.

Mixing of the component B: 77.6 parts of α,ω-divinyl polydimethyl siloxane (VS2000 commercially available from AB Specialty Silicones Co., Ltd, vinyl content: 0.2%, and viscosity (at 25°C): 2000 cP), 22.4 parts of vinyldimethylsiloxy capped polydimethylmethylvinyl siloxane (VDM65000 commercially available from AB Specialty Silicones Co., Ltd, vinyl content: 3.5%), 10 parts of the hydrogenated epoxy resin-modified polymethylvinylsiloxane terminated with a hydroxyl group, 10 parts of MQ silicone resin (VQM60 commercially available from AB Specialty Silicones Co., Ltd, vinyl content: 0.5%, and M/Q=0.65), 10 parts of titanium dioxide powder (particle size: 0.5 µm), 2 parts of fumed silica (particle size: 0.2 µm), 10 parts of reflective glass microspheres (particle size: 1.5 µm), 22.3 parts of Si-H dimethyl capped dimethylmethylhydrogen polysiloxane (XL13 commercially available from AB Specialty Silicones Co., Ltd, hydrogen content 0.38 wt.%), 0.005 parts of 1-hexyn-1-cyclohexanol, and 0.15 parts of epoxypropoxypropyltrimethoxysilane were stirred for 30 min at a rotation speed of 500 rpm, and then ground two times in a three-roller grinding mill (grinding parameter: inter-roller gap 30 µm), to obtain the component B having a fineness of 25 µm.

### (III) Preparation of the reflective coating

The component A and the component B were uniformly mixed at a weight ratio of 1: 1, to obtain a mixture having a viscosity of 8100 cP. The uniformly mixed silicone composition was printed onto a site of a back panel where reflection was needed by using a 100-mesh screen printing machine and then baked at 150°C for 10 min to form a reflective coating.

### Example 5

(I) Preparation of the hydrogenated epoxy resin-modified polymethylvinylsiloxane terminated with a hydroxyl group: The preparation method was the same as the method for preparing the hydrogenated epoxy resin-modified polymethylvinylsiloxane terminated with a hydroxyl group as described in Example 1.
(II) Material mixing of the component A and the component B in the silicone composition

Mixing of the component A: 100 parts of α,ω-divinyl polydimethyl siloxane (VS5000 commercially available from AB Specialty Silicones Co., Ltd, vinyl content: 0.16%, and viscosity (at 25°C): 5000 cP), 15 parts of the hydrogenated epoxy resin-modified polymethylvinylsiloxane terminated with a hydroxyl group, 10 parts of MQ silicone resin (VQM60 commercially available from AB Specialty Silicones Co., Ltd, vinyl content: 0.5%, and M/Q=0.65), 15 parts of titanium dioxide powder (particle size: 1µm), 3 parts of fumed silica (particle size: 0.5µm), 3 parts of reflective glass microspheres (particle size: 2µm), and 0.12 parts of Kaarst platinum catalyst (SYC-off 4000 commercially available from Dow Corning, in which the content of platinum is 0.5%) were stirred for 30 min at a rotation speed of 500 rpm, and then ground two times in a three-roller grinding mill (grinding parameter: inter-roller gap 30 µm), to obtain the component A having a fineness of 22 µm.

Mixing of the component B: 97.07 parts of α,ω-divinyl polydimethyl siloxane (VS5000 commercially available from AB Specialty Silicones Co., Ltd, vinyl content: 0.16%, and viscosity (at 25°C): 5000 cP), 15 parts of the hydrogenated epoxy resin-modified polymethylvinylsiloxane terminated with a hydroxyl group, 10 parts of MQ silicone resin (VQM60 commercially available from AB Specialty Silicones Co., Ltd, vinyl content: 0.5%, and M/Q=0.65), 15 parts of titanium dioxide powder, 3 parts of fumed silica, 3 parts of reflective glass microspheres, 5.66 parts of Si-H capped polydimethylmethylhydrogen polysiloxane (XL10 commercially available from AB Specialty Silicones Co., Ltd, hydrogen content 0.75 wt.%), 0.005 parts of ethynylcyclohexanol, and 0.15 parts of epoxypropoxypropyltrimethoxysilane were stirred for 30 min at a rotation speed of 500 rpm, and then ground two times in a three-roller grinding mill (grinding parameter: inter-roller gap 30 µm), to obtain the component B having a fineness of 22 µm.

### (III) Preparation of the reflective coating

The component A and the component B were uniformly mixed at a weight ratio of 1: 1, to obtain a mixture having a viscosity of 8500 cP. The uniformly mixed silicone composition was printed onto a site of a back panel where reflection was needed by using a 100-mesh screen printing machine and then baked at 120°C for 15 min to form a reflective coating.

### Example 6

(I) Preparation of the hydrogenated epoxy resin-modified polymethylvinylsiloxane terminated with a hydroxyl group: The preparation method was the same as the method for preparing the hydrogenated epoxy resin-modified polymethylvinylsiloxane terminated with a hydroxyl group as described in Example 1.
(II) Material mixing of the component A and the component B in the silicone composition

Mixing of the component A: 103 parts of α,ω-divinyl polydimethyl siloxane (VS5000 commercially available from AB Specialty Silicones Co., Ltd, vinyl content: 0.16%, and viscosity (at 25°C): 5000 cP), 5 parts of the hydrogenated epoxy resin-modified polymethylvinylsiloxane terminated with a hydroxyl group, 20 parts of MQ silicone resin (VQM60 commercially available from AB Specialty Silicones Co., Ltd, vinyl content: 0.5%, and M/Q=0.65), 8 parts of titanium dioxide powder (particle size: 1 µm), 2 parts of fumed silica (particle size: 0.5 µm), 10 parts of reflective glass microspheres (particle size: 2 µm), and 0.16 parts of Kaarst platinum catalyst (SYC-off 4000 commercially available from Dow Corning, in which the content of platinum is 0.5%) were stirred for 30 min at a rotation speed of 500 rpm, and then ground two times in a three-roller grinding mill (grinding parameter: inter-roller gap 40 µm), to obtain the component A having a fineness of 25 µm.

Mixing of the component B: 97.07 parts of α,ω-divinyl polydimethyl siloxane (VS5000 commercially available from AB Specialty Silicones Co., Ltd, vinyl content: 0.16%, and viscosity (at 25°C): 5000 cP), 5 parts of the hydrogenated epoxy resin-modified polymethylvinylsiloxane terminated with a hydroxyl group, 20 parts of MQ silicone resin (VQM60 commercially available from AB Specialty Silicones Co., Ltd, vinyl content: 0.5%, and M/Q=0.65), 8 parts of titanium dioxide powder (particle size: 1 µm), 2 parts of fumed silica (particle size: 0.5 µm), 6 parts of reflective glass microspheres (particle size: 2 µm), 5.66 parts of Si-H capped polydimethylmethylhydrogen siloxane (XL10 commercially available from AB Specialty Silicones Co., Ltd, hydrogen content: 0.75wt.%), 0.007 parts of ethynylcyclohexanol, and 0.4 parts of epoxypropoxypropyltrimethoxysilane were stirred for 30 min at a rotation speed of 500 rpm, and then ground two times in a three-roller grinding mill (grinding parameter: inter-roller gap 40 µm), to obtain the component B having a fineness of 25 µm.

### (III) Preparation of the reflective coating

The component A and the component B were uniformly mixed at a weight ratio of 1: 1, to obtain a mixture having a viscosity of 6500 cP. The uniformly mixed silicone composition was printed onto a site of a back panel where reflection was needed by using a 100-mesh screen printing machine and then baked at 150°C for 8 min to form a reflective coating.

### Example 7

(I) Preparation of the cycloaliphatic epoxy resin-modified polymethylvinylsiloxane terminated with a hydroxyl group: Reference was made to the method for preparing the hydrogenated epoxy resin-modified polymethylvinylsiloxane terminated with a hydroxyl group as described in Example 1, except that an cycloaliphatic epoxy resin (JE-8421 commercially available from Jiadida Co. Ltd., epoxy equivalent: 135) was used in place of the hydrogenated bis-phenol Aepoxy resin.
(II) Material mixing of the component A and the component B in the silicone composition: The material mixing methods were the same as those of the component A and the component B in the silicone composition as described in Example 1.
(III) Preparation of the reflective coating: The reflective coating was prepared following the same method as described in Example 1.

### Comparative Example 1

The method was as described in Example 1, except that no epoxy resin-modified polymethylvinylsiloxane terminated with a hydroxyl group was added in the components A and B.

### Comparative Example 2

The method was as described in Example 1, except that no reflective glass microspheres were contained in the components A and B.

Comparative Example 3 (Reflective coating prepared with a one-component condensation-type silicone adhesive)
(I) Mixing of the silicone composition: 200 parts by weight of a one-component condensation-type white silicone adhesive (1527W one-component condensation-type silicone adhesive commercially available from Tianshan Co. Ltd.) was stirred with 20 parts of reflective glass microspheres (particle size: 2 µm) for 30 min at a rotation speed of 500 rpm under vacuum.
(II) Preparation of reflective coating

The uniformly mixed silicone composition was coated onto a site of a back panel where reflection was needed by means of extrusion and knife coating, and stood for 48 hrs at room temperature to form a reflective coating.

Comparative Example 4 (Reflective coating prepared with a two-component addition-type silicone adhesive)
(I) Mixing of the silicone composition: 200 parts by weight of a two-component addition-type silicone adhesive (TB0330 two-component addition-type silicone adhesive commercially available from Rainbow Adhesive Co., Ltd.) was stirred with 20 parts of reflective glass microspheres (particle size: 2 µm) and 0.15 parts of epoxypropoxypropyltrimethoxysilane for 30 min at a rotation speed of 500 rpm, and then ground 2 times in a three-roller grinding mill (grinding parameter: inter-roller gap 30 µm), to obtain a silicone composition having a fineness of 25 µm.
(II) Preparation of reflective coating

The uniformly mixed silicone composition was printed onto a site of a back panel where reflection was needed by using a 100-mesh screen printing machine and then baked at 150°C for 30 min to form a reflective coating.

The reflective coatings prepared in Examples 1 to 7 and Comparative Examples 1 to 4 were amenable to the following tests.

### (I) Test items and methods

(1) Adhesion force: A corresponding reflective coating was formed on a glass surface (area: 50mm^{∗}50mm) with the silicone composition by using the method for preparing a reflective coating as described in Examples 1 to 7 and Comparative Examples 1 to 4, and then tested following GB/T 9286-1998.
(2) Adhesion force after 1000 hrs at double 85 (an environment with a temperature of 85°C and a humidity of 85%): A corresponding reflective coating was formed on a glass surface (area: 50mm^{∗}50mm) with the silicone composition by using the method for preparing a reflective coating as described in Examples 1 to 7 and Comparative Examples 1 to 4, stood for 1000 hrs in an environment with a temperature of 85°C and a humidity of 85%, and then removed for test following GB/T 9286-1998.
(3) Yellowing index

### Testing instrument: Yellowing tester

Fabrication of test samples (at least three groups): A reflective coating of 0.15 ± 0.05 mm in thickness was evenly coated onto a glass surface with the silicone composition by using the method for preparing a reflective coating as described in Examples 1 to 7 and Comparative Examples 1 to 4.

Testing index: Δb value (i.e., the yellowness index) of the coating. The difference between the b values before and after aging for 1000 hrs at double 85 (temperature 85°C and 85% humidity), that is, Δb after 1000 hrs at double 85, was calculated.

### (4) Reflectivity

### Testing instrument: Transmittance/reflectivity tester

Fabrication of test samples (at least three groups): A reflective coating of 0.15 ± 0.05 mm in thickness was evenly coated onto a glass surface with the silicone composition by using the method for preparing a reflective coating as described in Examples 1 to 7 and Comparative Examples 1 to 4.

Testing index: uniformity in coating reflectivity. The ratio of the intensity of light reflected by the coating to the intensity of the light incident on the coating was measured.

### (II) The test results are shown in Table 1.

**Table 1.**

| | Adhesion force | 1000 hrs at double 85 | | Reflectivity (%) |
|---|---|---|---|---|
| | | Adhesion force | Index Δb | |
| Example 1 | Grade 0 | Grade 0 | 0.46 | 92% |
| Example 2 | Grade 0 | Grade 0 | 0.45 | 92% |
| Example 3 | Grade 0 | Grade 0 | 0.42 | 92% |
| Example 4 | Grade 0 | Grade 0 | 0.44 | 92% |
| Example 5 | Grade 0 | Grade 0 | 0.43 | 93% |
| Example 6 | Grade 0 | Grade 0 | 0.44 | 91% |
| Example 7 | Grade 0 | Grade 0 | 0.42 | 92% |
| Comparative Example 1 | Grade 4 | Grade 5 | 0.4 | 92% |
| Comparative Example 2 | Grade 0 | Grade 0 | 0.6 | 65% |
| Comparative Example 3 | Grade 2 | Grade 3 | 0.7 | 72% |
| Comparative Example 4 | Grade 1 | Grade 2 | 0.8 | 69% |

As can be seen from the data in Table 2, by using a liquid polysiloxane having at least two Si-Vi bonds per molecule, an epoxy resin-modified polymethylvinylsiloxane terminated with a hydroxyl group, and a siloxane resin having at least two Si-Vi bonds as a base polymer component, and a polyorganosiloxane having at least two Si-H bonds as a cross-linking agent, a silicone adhesive composition with a much more moderate bonding strength can be obtained. By means of the silicone adhesive composition, the curing time is reduced and the adhesion force of a reflective coating prepared therewith is increased. Meanwhile, in the silicone adhesive composition, a high proportion of a reflective material can be mixed to obtain a high reflectivity, thereby improving the solar energy utilization of a photovoltaic assembly containing a reflective coating prepared therefrom.

## Claims

1. A silicone composition obtained by mixing component A and component B, comprising a base polymer component, a catalyst, a cross-linking agent and reflective particles, wherein the base polymer component, the catalyst and the cross-linking agent are not mixed simultaneously before use; the base polymer component comprises 100 parts by weight of at least one of α,ω-divinyl polydimethyl siloxane and vinyldimethylsiloxy capped polydimethylmethylvinylsiloxane, 5-15 parts by weight of a hydrogenated epoxy resin- or cycloaliphatic epoxy resin-modified polymethylvinylsiloxane terminated with a hydroxyl group, and 10-20 parts by weight of a siloxane resin having at least two Si-Vi bonds, wherein the siloxane resin has a vinyl content of 0.5-1.5 wt.%; and the cross-linking agent is a polyorganosiloxane having at least two Si-H bonds, wherein
the component A comprises:
45-55 parts by weight of at least one of α,ω-divinyl polydimethyl siloxane and vinyldimethylsiloxy capped polydimethylmethylvinylsiloxane;
2.5-7.5 parts by weight of the hydrogenated epoxy resin- or cycloaliphatic epoxy resin-modified polymethylvinylsiloxane terminated with a hydroxyl group;
5-10 parts by weight of the siloxane resin having at least two Si-Vi bonds, wherein the siloxane resin has a vinyl content of 0.5-1.5 wt.%;
0.015-0.075 parts by weight of the catalyst; and
1.5-5 parts by weight of the reflective particles; and
the component B comprises:
45-55 parts by weight of at least one of α,ω-divinyl polydimethyl siloxane and vinyldimethylsiloxy capped polydimethylmethylvinylsiloxane;
2.5-7.5 parts by weight of the hydrogenated epoxy resin- or cycloaliphatic epoxy resin-modified polymethylvinylsiloxane terminated with a hydroxyl group;
5-10 parts by weight of the siloxane resin having at least two Si-Vi bonds, wherein the siloxane resin has a vinyl content of 0.5-1.5 wt.%;
0.75-10 parts by weight of the polyorganosiloxane cross-linking agent having at least two Si-H bonds; and
1.5-5 parts by weight of the reflective particles.

2. The silicone composition according to claim 1, wherein the hydrogenated epoxy resin- or cycloaliphatic epoxy resin-modified polymethylvinylsiloxane terminated with a hydroxyl group is a modified product formed through the polymerization reaction of a hydrogenated epoxy resin or a cycloaliphatic epoxy resin with a methylvinyl polysiloxane terminated with a hydroxyl group, at a weight ratio of 1:0.5-2.5.

3. The silicone composition according to any one of claims 1 and 2, wherein the epoxy resin has an epoxy equivalent of 130-250.

4. The silicone composition according to any one of the preceding claims, wherein the polyorganosiloxane having at least two Si-H bonds has a hydrogen content of 0.1-1 wt.%.

5. The silicone composition according to any one of the preceding claims, wherein the catalyst is a platinum catalyst, in particular the platinum catalyst is a platinum-vinyl siloxane complex, in which the platinum content is 500-5000 ppm.

6. The silicone composition according to any one of the preceding claims, wherein the reflective particles are reflective glass microspheres having a particle size of 0.5-3 µm.

7. The silicone composition according to any one of the preceding claims, wherein the silicone composition further comprises, based on 100 parts by weight of at least one of α,ω-divinyl polydimethyl siloxane and vinyldimethylsiloxy capped polydimethylmethylvinylsiloxane, 0.002-0.005 parts by weight of an inhibitor, in particular the inhibitor is mixed in the component B.

8. The silicone composition according to any one of the preceding claims, wherein the silicone composition further comprises, based on 100 parts by weight of the at least one of α,ω-divinyl polydimethyl siloxane and vinyldimethylsiloxy capped polydimethylmethylvinylsiloxane, 0.05-0.3 parts by weight of a tackifier, in particular the tackifier is mixed in the component B.

9. The silicone composition according to any one of the preceding claims, wherein the silicone composition further comprises, based on 100 parts by weight of at least one of α,ω-divinyl polydimethyl siloxane and vinyldimethylsiloxy capped polydimethylmethylvinylsiloxane, 5-20 parts by weight of a mechanical functional filler.

10. A reflective coating, formed by mixing and then curing the silicone composition according to any one of the preceding claims.

11. A method for preparing the reflective coating according to claim 10, comprising the steps of:
mixing a portion of a base polymer component, a portion of reflective particles, an optional mechanical functional filler, and a catalyst under a first stirring condition, to obtain a mixed component A;
mixing the remaining base polymer component, the remaining reflective particles, the optional mechanical functional filler, a cross-linking agent, an optional inhibitor, and an optional tackifier under a second stirring condition, to obtain a mixed component B; and
mixing the mixed component A and the mixed component B with stirring, to obtain a pre-material having a viscosity of 6000-10000 cP; and applying the pre-material onto a substrate, and curing under a curing condition, to form a reflective coating,
wherein the base polymer component comprises 100 parts by weight of at least one of α,ω-divinyl polydimethyl siloxane and vinyldimethylsiloxy capped polydimethylmethylvinylsiloxane, 5-15 parts by weight of a hydrogenated epoxy resin- or cycloaliphatic epoxy resin-modified polymethylvinylsiloxane terminated with a hydroxyl group, and 10-20 parts by weight of a siloxane resin having at least two Si-Vi bonds, wherein the siloxane resin has a vinyl content of 0.5-1.5 wt.%, and the cross-linking agent is a polyorganosiloxane having at least two Si-H bonds;
wherein component A comprises:
45-55 parts by weight of at least one of α,ω-divinyl polydimethyl siloxane and vinyldimethylsiloxy capped polydimethylmethylvinylsiloxane;
2.5-7.5 parts by weight of the hydrogenated epoxy resin- or cycloaliphatic epoxy resin-modified polymethylvinylsiloxane terminated with a hydroxyl group;
5-10 parts by weight of the siloxane resin having at least two Si-Vi bonds, wherein the siloxane resin has a vinyl content of 0.5-1.5 wt.%;
0.015-0.075 parts by weight of the catalyst; and
1.5-5 parts by weight of the reflective particles; and
component B comprises:
45-55 parts by weight of at least one of α,ω-divinyl polydimethyl siloxane and vinyldimethylsiloxy capped polydimethylmethylvinylsiloxane;
2.5-7.5 parts by weight of the hydrogenated epoxy resin- or cycloaliphatic epoxy resin-modified polymethylvinylsiloxane terminated with a hydroxyl group;
5-10 parts by weight of the siloxane resin having at least two Si-Vi bonds, wherein the siloxane resin has a vinyl content of 0.5-1.5 wt.%;
0.75-10 parts by weight of the polyorganosiloxane cross-linking agent having at least two Si-H bonds; and
1.5-5 parts by weight of the reflective particles.

12. The method according to claim 11, wherein
the first stirring condition and the second stirring condition comprise respectively high-speed stirring at 2000-7000 rpm for 20-40 min; and
the curing condition comprises baking at 120-150°C for 5-15 min.

13. A photovoltaic assembly, comprising a back panel and a reflective coating covering the back panel, wherein the reflective coating is a reflective coating as defined in claim 10.

## Patentansprüche

1. Silikonzusammensetzung, die durch Mischen einer Komponente A und einer Komponente B erhalten wird und eine Basispolymer-Komponente, einen Katalysator, ein Vernetzungsmittel und reflektierende Partikel umfasst, wobei die Basispolymer-Komponente, der Katalysator und das Vernetzungsmittel vor der Benutzung nicht gleichzeitig vermischt werden; wobei die Basispolymer-Komponente umfasst: 100 Gewichtsteile von wenigstens einem aus α,ω-Divinylpolydimethylsiloxan und mit Vinyldimethylsiloxy überkapptem Polydimethylmethylvinylsiloxan, 5-15 Gewichtsteile eines mit hydriertem Epoxidharz oder cycloaliphatischem Epoxidharz modifizierten Polymethylvinylsiloxans, das mit einer Hydroxygruppe endet, und 10-20 Gewichtsteile eines Siloxanharzes mit wenigstens zwei Si-Vi-Bindungen, wobei das Siloxanharz einen Vinylgehalt von 0,5-1,5 Gew.-% aufweist; und das Vernetzungsmittel ein Polyorganosiloxan mit wenigstens zwei Si-H-Bindungen ist, wobei
die Komponente A umfasst:
45-55 Gewichtsteile von wenigstens einem aus α,ω-Divinylpolydimethylsiloxan und mit Vinyldimethylsiloxy überkapptem Polydimethylmethylvinylsiloxan;
2,5-7,5 Gewichtsteile des mit hydriertem Epoxidharz oder cycloaliphatischem Epoxidharz modifizierten Polymethylvinylsiloxans, das mit einer Hydroxygruppe endet;
5-10 Gewichtsteile des Siloxanharzes mit wenigstens zwei Si-Vi-Bindungen, wobei das Siloxanharz einen Vinylgehalt von 0,5-1,5 Gew.-% aufweist;
0,015-0,075 Gewichtsteile des Katalysators; und
1,5-5 Gewichtsteile der reflektierenden Partikel; und
die Komponente B umfasst:
45-55 Gewichtsteile von wenigstens einem aus α,ω-Divinylpolydimethylsiloxan und mit Vinyldimethylsiloxy überkapptem Polydimethylmethylvinylsiloxan;
2,5-7,5 Gewichtsteile des mit hydriertem Epoxidharz oder cycloaliphatischem Epoxidharz modifizierten Polymethylvinylsiloxans, das mit einer Hydroxygruppe endet;
5-10 Gewichtsteile des Siloxanharzes mit wenigstens zwei Si-Vi-Bindungen, wobei das Siloxanharz einen Vinylgehalt von 0,5-1,5 Gew.-% aufweist;
0,75-10 Gewichtsteile des Polyorganosiloxan-Vernetzungsmittels mit wenigstens zwei Si-H-Bindungen; und
1,5-5 Gewichtsteile der reflektierenden Partikel.

2. Silikonzusammensetzung nach Anspruch 1, wobei das mit hydriertem Epoxidharz oder cycloaliphatischem Epoxidharz modifizierte Polymethylvinylsiloxan, das mit einer Hydroxygruppe endet, ein modifiziertes Produkt ist, das durch die Polymerisationsreaktion eines hydrierten Epoxidharzes oder eines cycloaliphatischen Epoxidharzes mit einem Methylvinylpolysiloxan, das mit einer Hydroxygruppe endet, mit einem Gewichtsverhältnis von 1 : 0,5-2,5 gebildet wird.

3. Silikonzusammensetzung nach einem der Ansprüche 1 und 2, wobei das Epoxidharz ein Epoxidäquivalent von 130-250 aufweist.

4. Silikonzusammensetzung nach einem der vorhergehenden Ansprüche, wobei das Polyorganosiloxan mit wenigstens zwei Si-H-Bindungen einen Wasserstoffgehalt von 0,1-1 Gew.-% aufweist.

5. Silikonzusammensetzung nach einem der vorhergehenden Ansprüche, wobei der Katalysator ein Platin-Katalysator ist und der Platin-Katalysator insbesondere ein Platin-Vinylsiloxan-Komplex ist, in dem der Platingehalt 500-5000 ppm beträgt.

6. Silikonzusammensetzung nach einem der vorhergehenden Ansprüche, wobei die reflektierenden Partikel reflektierende Glas-Mikrokügelchen mit einer Partikelgröße von 0,5-3 µm sind.

7. Silikonzusammensetzung nach einem der vorhergehenden Ansprüche, wobei die Silikonzusammensetzung ferner - bezogen auf 100 Gewichtsteile von wenigstens einem aus α,ω-Divinylpolydimethylsiloxan und mit Vinyldimethylsiloxy überkapptem Polydimethylmethylvinylsiloxan - 0,002-0,005 Gewichtsteile eines Inhibitors umfasst und der Inhibitor insbesondere in die Komponente B eingemischt ist.

8. Silikonzusammensetzung nach einem der vorhergehenden Ansprüche, wobei die Silikonzusammensetzung ferner - bezogen auf 100 Gewichtsteile des wenigstens einen aus α,ω-Divinylpolydimethylsiloxan und mit Vinyldimethylsiloxy überkapptem Polydimethylmethylvinylsiloxan - 0,05-0,3 Gewichtsteile eines Klebrigmachers umfasst und der Klebrigmacher insbesondere in die Komponente B eingemischt ist.

9. Silikonzusammensetzung nach einem der vorhergehenden Ansprüche, wobei die Silikonzusammensetzung ferner - bezogen auf 100 Gewichtsteile von wenigstens einem aus α,ω-Divinylpolydimethylsiloxan und mit Vinyldimethylsiloxy überkapptem Polydimethylmethylvinylsiloxan - 5-20 Gewichtsteile eines mechanischen funktionellen Füllstoffs umfasst.

10. Reflektierende Beschichtung, die durch Mischen und nachfolgendes Härten der Silikonzusammensetzung nach einem der vorhergehenden Ansprüche ausgebildet ist.

11. Verfahren zum Herstellen der reflektierenden Beschichtung nach Anspruch 10, das folgende Schritte umfasst:
Mischen einer Teilmenge einer Basispolymer-Komponente, einer Teilmenge reflektierender Partikel, eines optionalen mechanischen funktionellen Füllstoffs und eines Katalysators unter einer ersten Rührbedingung, um eine gemischte Komponente A zu erhalten;
Mischen der verbleibenden Basispolymer-Komponente, der verbleibenden reflektierenden Partikel, des optionalen mechanischen funktionellen Füllstoffs, eines Vernetzungsmittels, eines optionalen Inhibitors und eines optionalen Klebrigmachers unter einer zweiten Rührbedingung, um eine gemischte Komponente B zu erhalten; und
Mischen der gemischten Komponente A und der gemischten Komponente B unter Rühren, um ein Vormaterial mit einer Viskosität von 6000-10000 cP zu erhalten;
und Aufbringen des Vormaterials auf ein Substrat und Härten unter einer Härtungsbedingung, um eine reflektierende Beschichtung auszubilden,
wobei die Basispolymer-Komponente umfasst: 100 Gewichtsteile von wenigstens einem aus α,ω-Divinylpolydimethylsiloxan und mit Vinyldimethylsiloxy überkapptem Polydimethylmethylvinylsiloxan, 5-15 Gewichtsteile eines mit hydriertem Epoxidharz oder cycloaliphatischem Epoxidharz modifizierten Polymethylvinylsiloxans, das mit einer Hydroxygruppe endet, und 10-20 Gewichtsteile eines Siloxanharzes mit wenigstens zwei Si-Vi-Bindungen, wobei das Siloxanharz einen Vinylgehalt von 0,5-1,5 Gew.-% aufweist, und das Vernetzungsmittel ein Polyorganosiloxan mit wenigstens zwei Si-H-Bindungen ist;
wobei die Komponente A umfasst:
45-55 Gewichtsteile von wenigstens einem aus α,ω-Divinylpolydimethylsiloxan und mit Vinyldimethylsiloxy überkapptem Polydimethylmethylvinylsiloxan;
2,5-7,5 Gewichtsteile des mit hydriertem Epoxidharz oder cycloaliphatischem Epoxidharz modifizierten Polymethylvinylsiloxans, das mit einer Hydroxygruppe endet;
5-10 Gewichtsteile des Siloxanharzes mit wenigstens zwei Si-Vi-Bindungen, wobei das Siloxanharz einen Vinylgehalt von 0,5-1,5 Gew.-% aufweist;
0,015-0,075 Gewichtsteile des Katalysators; und
1,5-5 Gewichtsteile der reflektierenden Partikel; und
die Komponente B umfasst:
45-55 Gewichtsteile von wenigstens einem aus α,ω-Divinylpolydimethylsiloxan und mit Vinyldimethylsiloxy überkapptem Polydimethylmethylvinylsiloxan;
2,5-7,5 Gewichtsteile des mit hydriertem Epoxidharz oder cycloaliphatischem Epoxidharz modifizierten Polymethylvinylsiloxans, das mit einer Hydroxygruppe endet;
5-10 Gewichtsteile des Siloxanharzes mit wenigstens zwei Si-Vi-Bindungen, wobei das Siloxanharz einen Vinylgehalt von 0,5-1,5 Gew.-% aufweist;
0,75-10 Gewichtsteile des Polyorganosiloxan-Vernetzungsmittels mit wenigstens zwei Si-H-Bindungen; und
1,5-5 Gewichtsteile der reflektierenden Partikel.

12. Verfahren nach Anspruch 11, wobei
die erste Rührbedingung und die zweite Rührbedingung jeweils ein Hochgeschwindigkeitsrühren mit 2000-7000 min⁻¹ für 20-40 min umfassen; und
die Härtungsbedingung ein Wärmebehandeln bei 120-150 °C für 5-15 min umfasst.

13. Fotovoltaikbaugruppe, die eine Rückseitenplatte und eine reflektierende Beschichtung, welche die Rückseitenplatte bedeckt, umfasst, wobei die reflektierende Beschichtung eine reflektierende Beschichtung wie in Anspruch 10 definiert ist.

## Revendications

1. Composition siliconée obtenue en mélangeant un composant A et un composant B, comprenant un composant polymère de base, un catalyseur, un agent de réticulation et des particules réfléchissantes, dans laquelle le composant polymère de base, le catalyseur et l'agent de réticulation ne sont pas mélangés simultanément avant usage ; le composant polymère de base comprend 100 parties en masse d'au moins un composé parmi l'α,ω-divinylpolydiméthylsiloxane et le polydiméthylméthylvinylsiloxane coiffé de vinyldiméthylsiloxy, de 5 à 15 parties en masse d'un polyméthylvinylsiloxane modifié par une résine époxyde hydrogénée ou par une résine époxyde cycloaliphatique, et terminé par un groupe hydroxyle, et de 10 à 20 parties en masse d'une résine siloxane comportant au moins deux liaisons Si-Vi, dans laquelle la résine siloxane présente un pourcentage massique en vinyle de 0,5 à 1,5 % ; et l'agent de réticulation est un polyorganosiloxane comportant au moins deux liaisons Si-H, dans laquelle
le composant A comprend :
de 45 à 55 parties en masse d'au moins un composé parmi l'α,ω-divinylpolydiméthylsiloxane et le polydiméthylméthylvinylsiloxane coiffé de vinyldiméthylsiloxy ;
de 2,5 à 7,5 parties en masse de polyméthylvinylsiloxane modifié par une résine époxyde hydrogénée ou par une résine époxyde cycloaliphatique, et terminé par un groupe hydroxyle ;
de 5 à 10 parties en masse de résine siloxane comportant au moins deux liaisons Si-Vi, dans laquelle la résine siloxane présente un pourcentage massique en vinyle de 0,5 à 1,5 % ;
de 0,015 à 0,075 partie en masse de catalyseur ; et
de 1,5 à 5 parties en masse de particules réfléchissantes ; et
le composant B comprend :
de 45 à 55 parties en masse d'au moins un composé parmi l'α,ω-divinylpolydiméthylsiloxane et le polydiméthylméthylvinylsiloxane coiffé de vinyldiméthylsiloxy ;
de 2,5 à 7,5 parties en masse de polyméthylvinylsiloxane modifié par une résine époxyde hydrogénée ou par une résine époxyde cycloaliphatique, et terminé par un groupe hydroxyle ;
de 5 à 10 parties en masse de résine siloxane comportant au moins deux liaisons Si-Vi, dans laquelle la résine siloxane présente un pourcentage massique en vinyle de 0,5 à 1,5 % ;
de 0,75 à 10 parties en masse d'agent de réticulation polyorganosiloxane comportant au moins deux liaisons Si-H ; et
de 1,5 à 5 parties en masse de particules réfléchissantes.

2. Composition siliconée selon la revendication 1, dans laquelle le polyméthylvinylsiloxane modifié par une résine époxyde hydrogénée ou par une résine époxyde cycloaliphatique, et terminé par un groupe hydroxyle, est un produit modifié formé par la réaction de polymérisation d'une résine époxyde hydrogénée ou d'une résine époxyde cycloaliphatique avec un méthylvinylpolysiloxane terminé par un groupe hydroxyle, avec un rapport massique de 1:0,5 à 1:2,5.

3. Composition siliconée selon l'une quelconque des revendications 1 et 2, dans laquelle la résine époxyde présente un équivalent époxy de 130 à 250.

4. Composition siliconée selon l'une quelconque des revendications précédentes, dans laquelle le polyorganosiloxane comportant au moins deux liaisons Si-H présente un pourcentage massique d'hydrogène de 0,1 à 1 %.

5. Composition siliconée selon l'une quelconque des revendications précédentes, dans laquelle le catalyseur est un catalyseur au platine, dans laquelle en particulier le catalyseur au platine est un complexe platine-vinylsiloxane, où la concentration en platine est de 500 à 5.000 ppm.

6. Composition siliconée selon l'une quelconque des revendications précédentes, dans laquelle les particules réfléchissantes sont des microsphères de verre réfléchissantes présentant une taille de particule de 0,5 à 3 µm.

7. Composition siliconée selon l'une quelconque des revendications précédentes, dans laquelle la composition siliconée comprend en outre, sur base de 100 parties en masse d'au moins un composé parmi l'α,ω-divinylpolydiméthylsiloxane et le polydiméthylméthylvinylsiloxane coiffé de vinyldiméthylsiloxy, de 0,002 à 0,005 partie en masse d'un inhibiteur, dans laquelle en particulier l'inhibiteur est mélangé dans le composant B.

8. Composition siliconée selon l'une quelconque des revendications précédentes, dans laquelle la composition siliconée comprend en outre, sur base de 100 parties en masse dudit au moins un composé parmi l'α,ω-divinylpolydiméthylsiloxane et le polydiméthylméthylvinylsiloxane coiffé de vinyldiméthylsiloxy, de 0,05 à 0,3 partie en masse de résine tackifiante, dans laquelle en particulier la résine tackifiante est mélangée dans le composant B.

9. Composition siliconée selon l'une quelconque des revendications précédentes, dans laquelle la composition siliconée comprend en outre, sur base de 100 parties en masse d'au moins un composé parmi l'α,ω-divinylpolydiméthylsiloxane et le polydiméthylméthylvinylsiloxane coiffé de vinyldiméthylsiloxy, de 5 à 20 parties en masse d'une charge à fonction mécanique.

10. Revêtement réfléchissant formé en mélangeant et en laissant ensuite polymériser la composition siliconée selon l'une quelconque des revendications précédentes.

11. Procédé de préparation du revêtement réfléchissant selon la revendication 10, comprenant les étapes suivantes :
mélange d'une portion de composant polymère de base, d'une portion de particules réfléchissantes, éventuellement d'une charge à fonction mécanique, et d'un catalyseur, sous une première condition d'agitation, pour obtenir un composant mélangé A ;
mélange du composant polymère de base restant, des particules réfléchissantes restantes, éventuellement de la charge à fonction mécanique, d'un agent de réticulation, éventuellement d'un inhibiteur, et éventuellement d'une résine tackifiante, sous une deuxième condition d'agitation, pour obtenir un composant mélangé B ; et
mélange du composant mélangé A et du composant mélangé B par agitation, pour obtenir une matière brute présentant une viscosité de 6.000 à 10.000 cP ;
et application de la matière brute sur un substrat et polymérisation sous une condition de polymérisation, pour former un revêtement réfléchissant,
dans lequel le composant polymère de base comprend 100 parties en masse d'au moins un composé parmi l'α,ω-divinylpolydiméthylsiloxane et le polydiméthylméthylvinylsiloxane coiffé de vinyldiméthylsiloxy, de 5 à 15 parties en masse d'un polyméthylvinylsiloxane modifié par une résine époxyde hydrogénée ou par une résine époxyde cycloaliphatique, et terminé par un groupe hydroxyle, et de 10 à 20 parties en masse d'une résine siloxane comportant au moins deux liaisons Si-Vi, dans lequel la résine siloxane présente un pourcentage massique en vinyle de 0,5 à 1,5 %, et l'agent de réticulation est un polyorganosiloxane comportant au moins deux liaisons Si-H ;
dans lequel le composant A comprend :
de 45 à 55 parties en masse d'au moins un composé parmi l'α,ω-divinylpolydiméthylsiloxane et le polydiméthylméthylvinylsiloxane coiffé de vinyldiméthylsiloxy ;
de 2,5 à 7,5 parties en masse de polyméthylvinylsiloxane modifié par une résine époxyde hydrogénée ou par une résine époxyde cycloaliphatique, et terminé par un groupe hydroxyle ;
de 5 à 10 parties en masse de résine siloxane comportant au moins deux liaisons Si-Vi, dans lequel la résine siloxane présente un pourcentage massique en vinyle de 0,5 à 1,5 % ;
de 0,015 à 0,075 partie en masse de catalyseur ; et
de 1,5 à 5 parties en masse de particules réfléchissantes ; et
le composant B comprend :
de 45 à 55 parties en masse d'au moins un composé parmi l'α,ω-divinylpolydiméthylsiloxane et le polydiméthylméthylvinylsiloxane coiffé de vinyldiméthylsiloxy ;
de 2,5 à 7,5 parties en masse de polyméthylvinylsiloxane modifié par une résine époxyde hydrogénée ou par une résine époxyde cycloaliphatique, et terminé par un groupe hydroxyle ;
de 5 à 10 parties en masse de résine siloxane comportant au moins deux liaisons Si-Vi, dans lequel la résine siloxane présente un pourcentage massique en vinyle de 0,5 à 1,5 % ;
de 0,75 à 10 parties en masse d'agent de réticulation polyorganosiloxane comportant au moins deux liaisons Si-H ; et
de 1,5 à 5 parties en masse de particules réfléchissantes.

12. Procédé selon la revendication 11, dans lequel
la première condition d'agitation et la deuxième condition d'agitation comprennent respectivement une agitation à haute vitesse entre 2.000 et 7.000 tr/min durant 20 à 40 min ; et
la condition de polymérisation comprend une cuisson entre 120 °C et 150 °C durant 5 à 15 min.

13. Ensemble photovoltaïque, comprenant un panneau arrière et un revêtement réfléchissant qui recouvre le panneau arrière, dans lequel le revêtement réfléchissant est un revêtement réfléchissant tel que défini dans la revendication 10.
